# FASCICULE DE BREVET EUROPEEN

(11) **EP 3 529 664 B1**
(45) Date de publication et mention de la délivrance du brevet: **17.03.2021**
(21) Numéro de dépôt: 17797396.3
(22) Date de dépôt: 20.10.2017
(51) Int. Cl.: G03F 7/00

(54) **PROCÉDÉ DE FORMATION D'UN GUIDE D'ASSEMBLAGE FONCTIONNALISÉ ET PROCÉDÉ DE GRAPHO-ÉPITAXIE**
VERFAHREN ZUR HERSTELLUNG EINER FUNKTIONALISIERTEN MONTAGEFÜHRUNG UND GRAPHO-EPITAXIE-VERFAHREN
METHOD FOR FORMING A FUNCTIONALISED ASSEMBLY GUIDE AND PROCESS OF GRAPHO-EPITAXY

(30) Priorité: 21.10.2016 FR 1660231
(43) Date de publication de la demande: 28.08.2019
(73) Titulaire: Commissariat à l'Énergie Atomique et aux Énergies Alternatives, 75015 Paris (FR)
(72) Inventeur: CLAVEAU, Guillaume, 38000 Grenoble (FR); ARGOUD, Maxime, 38110 La Chapelle De La Tour (FR); POSSEME, Nicolas, 38360 Sassenage (FR); TIRON, Raluca, 38950 Saint-Martin-Le-Vinoux (FR)
(74) Mandataire: Cabinet Camus Lebkiri
(86) Numéro de dépôt international: PCT/FR2017/052890
(87) Numéro de publication internationale: WO 2018/073550

(56) Documents cités:
- EP-A1- 2 998 981
- EP-A1- 3 125 320
- FR-A1- 3 021 321
- KR-A- 20160 032 702
- US-A1- 2016 244 581

## Description

### DOMAINE TECHNIQUE

La présente invention concerne un procédé de formation d'un guide d'assemblage fonctionnalisé destiné à l'auto-assemblage d'un copolymère à blocs. La présente invention concerne également un procédé de grapho-épitaxie utilisant un guide d'assemblage fonctionnalisé obtenu par un tel procédé.

### ÉTAT DE LA TECHNIQUE

Le besoin en procédés permettant de réaliser des motifs de dimensions nanométriques a fortement augmenté ces dernières années, en raison de la tendance à la miniaturisation des composants électroniques.

Parmi les technologies de lithographie émergentes, on peut citer les techniques d'auto-assemblage dirigé de copolymères à blocs (« Directed Self-Assembly, DSA). Les copolymères à blocs sont des polymères dans lesquels deux unités de répétition, un monomère A et un monomère B, forment des chaînes liées entre elles par une liaison covalente. Lorsque l'on donne suffisamment de mobilité aux chaînes, par exemple en chauffant ces copolymères à blocs, les chaînes de monomère A et les chaînes de monomère B ont tendance à se séparer en phases ou blocs de polymère et à se réorganiser sous des conformations spécifiques, qui dépendent notamment du ratio entre le monomère A et le monomère B. En fonction de ce ratio, on peut avoir des sphères de A dans une matrice de B, ou bien des cylindres de A dans une matrice de B, ou encore des lamelles de A et des lamelles de B intercalées.

Les copolymères à blocs ont donc la propriété de former des motifs de polymère qui peuvent être contrôlés grâce au ratio des monomères A et B. La périodicité de ces motifs est directement reliée à la masse molaire des copolymères à blocs. Ainsi, en contrôlant cette masse molaire, on peut contrôler la résolution des motifs de polymère formés par les copolymères à blocs.

Les propriétés des copolymères à blocs sont exploitées dans le cadre de procédés de grapho-épitaxie. La grapho-épitaxie consiste à former des motifs primaires appelés « motifs de guidage » à la surface d'un substrat, chaque motif de guidage délimitant une cavité à l'intérieur de laquelle une couche de copolymère à blocs est déposée. Les motifs de guidage permettent de contrôler l'organisation des blocs de copolymère pour former des motifs secondaires de plus haute résolution à l'intérieur des cavités. En effet, la contrainte mécanique exercée sur la couche de copolymère par les motifs de guidage et les interactions chimiques du copolymère avec les flancs des motifs de guidage favorisent la séparation des phases. Les motifs de guidage sont classiquement formés par photolithographie dans une couche de résine, et éventuellement, transférés dans un masque dur.

Il est souvent difficile de contrôler l'orientation des motifs secondaires par rapport à un motif de guidage. En effet, l'orientation des motifs secondaires par rapport au motif de guidage dépend des interactions des blocs de monomère avec la surface du motif de guidage, avec le substrat et avec l'air. Dans le cas du copolymère à blocs PS-b-PMMA, les interactions des deux phases - polystyrène (PS) et polyméthacrylate de méthyle (PMMA) - avec l'air sont équivalentes.

Si le fond et les parois latérales de la cavité présentent la même affinité préférentielle avec l'une des deux phases du copolymère à blocs, par exemple le PS, alors cette phase s'étendra sur les flancs du motif de guidage et sur le substrat. Autrement dit, l'autre phase du copolymère, le PMMA, ne s'étendra pas sur toute la hauteur du motif de guidage en raison d'une couche résiduelle de PS située à l'interface avec le substrat. Or cette couche résiduelle est préjudiciable pour le transfert, dans le substrat, des trous obtenus par la gravure sélective de la phase PMMA.

La configuration la plus avantageuse est de générer une cavité ayant un fond neutre (interactions équivalentes des deux blocs avec le substrat) et des parois latérales présentant une affinité préférentielle avec l'une des deux phases du polymère. Dans ce cas, l'autre phase de polymère (celle qui sera gravée sélectivement) s'étend jusqu'à l'interface avec le substrat.

Un contrôle des affinités de surface, sélectif entre le fond et les parois latérales de la cavité, est par conséquent nécessaire.

Une technique classique consiste à greffer une couche de neutralisation au fond de la cavité, tandis que les parois de la cavité restent nues (le motif de guidage ayant, par défaut, une affinité préférentielle pour l'une des phases). Pour ce faire, un polymère statistique est dilué, puis déposé par dépôt à la tournette (également appelé « spin coating ») à l'intérieur du motif de guidage. Cette technique ne laisse pas la possibilité de choisir l'affinité des parois latérales des cavités, car celle-ci est dictée par le matériau dans lequel la cavité est réalisée. Par ailleurs, tout traitement (dépôt, plasma...) visant à modifier l'affinité des parois de la cavité affectera également le fond de la cavité. De plus, cette technique donne de bons résultats pour une seule cavité ou pour plusieurs cavités de mêmes dimensions régulièrement réparties sur le substrat. Par contre, dès lors que la densité des cavités varie au sein du guide d'assemblage, la couche de polymère statistique se dépose aussi sur les parois latérales des cavités dans les zones les moins denses du guide d'assemblage.

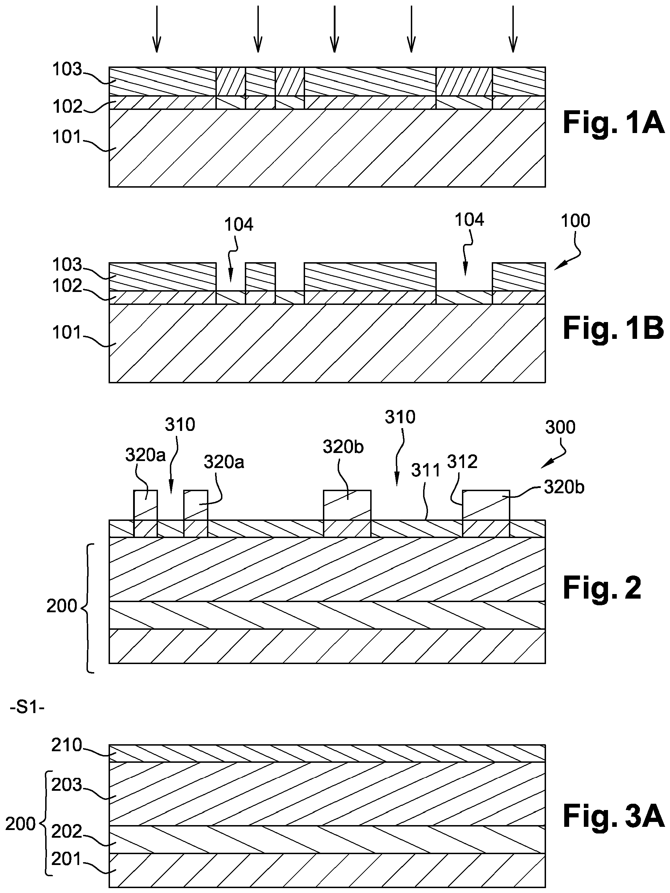

Les figures 1A et 1B illustrent les étapes d'un procédé de formation d'un guide d'assemblage fonctionnalisé 100, tel que décrit dans le document [«Soft Graphoexpitaxy of Block Copolymer Assembly with Disposable Photoresist », Seong-Jun Jeong et al., Nano Letters, vol.9, No. 6, 2300-2305, 2009]. À l'étape de la figure 1A, un substrat 101 est recouvert d'une couche de neutralisation 102 en copolymère statistique, puis d'une couche de résine 103 à tonalité de développement négative. Le guide d'assemblage 100 est formé par photolithographie, en exposant une partie seulement de la couche de résine 103 à des ultraviolets profonds (DUV, pour « deep ultraviolet » en anglais) puis en développant la couche de résine. Lors de l'étape de développement représentée par la figure 1B, les portions de la couche de résine 103 non-exposées aux ultraviolets sont retirées afin de former des cavités 104. La couche de neutralisation 102 constitue le fond des cavités 104.

Cette deuxième technique résout le problème lié à la densité variable des cavités mais présentent deux défauts majeurs. L'utilisation d'une résine pour former le guide d'assemblage ne laisse toujours pas la possibilité de choisir l'affinité des parois latérales des cavités, car celle-ci est dictée par la chimie de la résine. Par exemple, pour le copolymère à blocs PS-*b*-PMMA, la résine à tonalité de développement négative du document susmentionné présente une affinité pour le polystyrène. Tout traitement (dépôt, plasma...) visant à modifier l'affinité des parois des cavités affectera également le fond des cavités. Ainsi, le contrôle des interactions avec le copolymère à blocs déposé dans les cavités sera limité dans ce procédé de l'art antérieur. Par ailleurs, la résine présente une mauvaise tenue thermique qui réduit les possibilités de recuit pour l'assemblage du copolymère à blocs ou implique des variations dimensionnelles du guide d'assemblage (les flancs en résine du guide d'assemblage se déforment en chauffant)

EP 2 998 981 A1, US 2016/244581 A1, FR 3 021 321 A1 et EP3125320 A1, document visé à l'article 54(3) CBE, divulguent un procédé de formation d'un guide d'assemblage destiné à l'auto-assemblage d'un copolymère à blocs par grapho-épitaxie.

### RÉSUMÉ DE L'INVENTION

Il existe donc un besoin de prévoir un procédé de formation d'un guide d'assemblage permettant de choisir librement les affinités chimiques du fond et des parois latérales des cavités vis-à-vis du copolymère à blocs.

Selon l'invention, on tend à satisfaire ce besoin en prévoyant les étapes suivantes :
- former à la surface d'un substrat une couche de fonctionnalisation en un premier matériau présentant une première affinité chimique vis-à-vis du copolymère à blocs ;
- former sur la couche de fonctionnalisation un premier masque comprenant au moins un évidement ;
- déposer sur la couche de fonctionnalisation un deuxième matériau présentant une deuxième affinité chimique vis-à-vis du copolymère à blocs, de façon à remplir ledit au moins un évidement du premier masque ;
- graver le premier masque sélectivement par rapport aux premier et deuxième matériaux, d'où il résulte au moins un motif de guidage formé du deuxième matériau disposé sur la couche de fonctionnalisation.

On appelle ci-dessus « guide d'assemblage » une structure permettant de guider (ou diriger) l'auto-assemblage du copolymère à blocs. Cette structure comprend la couche de fonctionnalisation formée du premier matériau et un ou plusieurs motifs de guidage formés du deuxième matériau.

Les motifs de guidage, constitués du deuxième matériau, correspondent ainsi à la partie complémentaire du masque formé sur la couche de fonctionnalisation. Suivant leur nombre et leur géométrie, fixés par le nombre et la forme des évidements du masque, les motifs de guidage délimitent (au moins en partie) une ou plusieurs cavités destinées à être remplies d'un copolymère à blocs. Le fond de chaque cavité est constitué par la couche de fonctionnalisation formée du premier matériau et présente par conséquent la première affinité chimique. Les parois latérales de la cavité sont formées par les flancs du motif de guidage en deuxième matériau et présentent par conséquent la deuxième affinité chimique.

L'affinité chimique des parois latérales de la cavité n'est donc plus dictée par le matériau du masque, mais par le deuxième matériau déposé dans l'évidemment du masque. Ce deuxième matériau peut être choisi spécialement en fonction de l'affinité souhaitée. Ainsi, le procédé de formation selon l'invention permet une grande liberté dans le contrôle des interactions avec le copolymère à blocs. Cette liberté quant à l'affinité des parois ne se fait pas au détriment de l'affinité du fond de cavité puisque ce fond est protégé pendant la plus grande partie du procédé par les parties pleines du masque.

Ce procédé offre également la possibilité, pour former le guide d'assemblage, de choisir un deuxième matériau ayant une bonne tenue thermique, c'est-dire capable de supporter des températures élevées sans se dégrader ou se déformer. Cela permet d'avoir recours, pour la suite du procédé de grapho-épitaxie, à des recuits d'assemblage ou de greffage à plus haute température ou de plus longue durée.

Grâce à ce procédé, il est désormais possible de former facilement un guide d'assemblage comprenant au moins une cavité dont les parois présentent une affinité chimique différente de celle du fond de la cavité, autrement dit une deuxième affinité différente de la première affinité.

Avantageusement, le deuxième matériau est déposé de façon à remplir intégralement ledit au moins un évidement du premier masque et à former une surépaisseur au-dessus du premier masque. Le procédé comprend alors, avant l'étape de gravure du premier masque, une étape consistant à éliminer la surépaisseur afin de découvrir le premier masque.

Ainsi, comme le deuxième matériau est déposé de manière à déborder du masque (dans lequel est imprimé l'inverse du guide d'assemblage) puis finalement raboté pour pouvoir éliminer le masque, le procédé selon l'invention est insensible aux variations de la densité des évidements (i.e. du taux d'ouverture) dans le masque.

Les première et deuxième affinités chimiques peuvent être choisies parmi les possibilités suivantes :
- affinité préférentielle pour l'un quelconque des blocs du copolymère ; ou
- neutre, c'est-à-dire sans préférence pour l'un quelconque des blocs du copolymère (ou équivalente pour chacun des blocs du copolymère).

Lorsqu'un matériau ou une surface, par exemple le fond des cavités, est dit « neutre » vis-à-vis du copolymère à blocs, cela signifie que les forces d'interaction avec les différents blocs du copolymère sont équivalentes.

Selon un développement du procédé selon l'invention, le premier matériau est neutre par rapport aux blocs du copolymère à blocs et le deuxième matériau présente une affinité préférentielle pour l'un des blocs du copolymère à blocs.

De préférence, le premier masque est gravé par voie humide. Ainsi, l'affinité chimique de la couche de fonctionnalisation vis-vis du copolymère à blocs ne risque pas d'être modifiée. À l'inverse, dans les procédés de l'art antérieur, on a souvent recours à une étape de gravure ou d'ouverture du masque par plasma, qui altère l'affinité de la couche de fonctionnalisation située sous le masque.

Selon un développement, le procédé de formation comprend en outre les étapes suivantes :
- former sur la couche de fonctionnalisation un deuxième masque comprenant au moins un évidement ;
- déposer un troisième matériau présentant une troisième affinité chimique vis-à-vis du copolymère à blocs, de façon à remplir ledit au moins un évidement du deuxième masque ; et
- graver le deuxième masque sélectivement par rapport aux premier, deuxième et troisième matériaux, d'où il résulte au moins un motif formé du troisième matériau disposé sur la couche de fonctionnalisation.

Les premier et deuxième masques sont de préférence formés successivement dans une même couche inorganique et gravés simultanément. Alternativement, le deuxième masque est formé sur la couche de fonctionnalisation après la gravure du premier masque.

Le procédé selon l'invention peut également présenter une ou plusieurs des caractéristiques ci-dessous, considérées individuellement ou selon toutes les combinaisons techniquement possibles :
- ledit au moins un motif de guidage délimite au moins en partie une cavité de profondeur comprise entre 50 nm et 300 nm ;
- la surépaisseur du deuxième matériau est éliminée par planarisation mécano-chimique ;
- la surépaisseur du deuxième matériau est éliminée par gravure plasma ;
- la surépaisseur du deuxième matériau présente une surface plane et le deuxième matériau est gravé de manière uniforme ;
- la couche de fonctionnalisation est formée d'un polymère dont l'énergie de surface correspond à un régime de neutralité du copolymère à blocs destiné à occuper les cavités du guide. Il peut notamment s'agir d'un copolymère statistique de même nature chimique (i.e. comprenant les mêmes monomères) que le copolymère à blocs ;
- le deuxième matériau est choisi parmi un polymère réticulable (par exemple un dérivé styrènique ou un dérivé de méthacrylate), un oxyde de silicium, un nitrure de silicium, un nitrure de titane, un métal tel que l'or, le cuivre, le platine et le palladium ;
- le premier masque est un masque dur comprenant une couche anti-réflective ;
- le premier masque comprend une couche de résine photosensible ;
- le procédé comprend en outre le dépôt conforme d'une couche d'arrêt sur la couche de résine photosensible ; et
- ledit au moins un évidement du premier masque et/ou ledit au moins un évidement du deuxième masque débouchent sur la couche de fonctionnalisation.

L'invention concerne également un procédé de grapho-épitaxie comprenant la formation d'un guide d'assemblage à l'aide du procédé décrit ci-dessus, le guide d'assemblage délimitant au moins une cavité, et le dépôt d'un copolymère à blocs à l'intérieur de la cavité.

### BRÈVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
- les figures 1A et 1B représentent des étapes d'un procédé de formation de guide d'assemblage fonctionnalisé selon l'art antérieur ;
- la figure 2 illustre un guide d'assemblage fonctionnalisé obtenu par le procédé de formation selon l'invention ;
- les figures 3A à 3F représentent des étapes S1 à S6 permettant de fabriquer le guide d'assemblage fonctionnalisé de la figure 2, d'après un mode de mise en œuvre préférentiel du procédé selon l'invention ; et
- la figure 4 représente une étape S2' remplaçant les étapes S2 et S3 des figures 3B et 3C, d'après une variante de mise en œuvre du procédé selon l'invention ; et
- les figures 5A à 5E représentent des étapes optionnelles S7-S11 du procédé selon l'invention, venant à la suite de l'étape S5 de la figure 3E.

Pour plus de clarté, les éléments identiques ou similaires sont repérés par des signes de référence identiques sur l'ensemble des figures.

### DESCRIPTION DÉTAILLÉE D'AU MOINS UN MODE DE RÉALISATION

En référence à la figure 2, le procédé selon l'invention permet d'obtenir à la surface d'un substrat 200 un guide d'assemblage fonctionnalisé 300 comprenant une ou plusieurs cavités 310. Chaque cavité 310 est destinée à être remplie d'un copolymère à blocs afin de former à l'intérieur au moins un motif secondaire de haute résolution, par auto-assemblage dirigé du copolymère à blocs. Le fond 311 des cavités 310 est fonctionnalisé de façon à présenter une première affinité chimique vis-à-vis du copolymère à blocs, tandis que les parois latérales 312 des cavités sont fonctionnalisées de manière à présenter une deuxième affinité chimique vis-à-vis du copolymère à blocs. Les parois latérales 312 des cavités s'étendent, de préférence, perpendiculairement au plan du substrat 200.

Les cavités 310 du guide d'assemblage 300 peuvent adopter différentes géométries. Elles peuvent notamment prendre la forme d'un puits cylindrique, d'un puits rectangulaire ou elliptique, d'une tranchée ou toute autre forme adaptée aux procédés de grapho-épitaxie. Les cavités 310 présentent de préférence une profondeur comprise entre 50 nm et 300 nm.

Les figures 3A à 3F représentent des étapes S1 à S6 permettant de fabriquer un tel guide d'assemblage fonctionnalisé 300, d'après un mode de mise en œuvre préférentiel du procédé selon l'invention.

La première étape S1, illustrée par la figure 3A, consiste à former une couche de fonctionnalisation 210 à la surface du substrat 200. La couche de fonctionnalisation 210 est constituée d'un premier matériau, choisi en fonction de l'affinité chimique qu'on souhaite donner au fond des cavités du guide d'assemblage. Ce premier matériau est de préférence un matériau polymère, greffable ou réticulable, permettant de contrôler l'énergie de surface du substrat. La couche de fonctionnalisation 210 peut être également formée d'une monocouche auto-assemblée (également appelées SAM pour « Self-Assembled Monolayer » en anglais). De préférence, la couche de fonctionnalisation 210 présente une épaisseur sensiblement constante, comprise entre 2 nm et 15 nm.

De préférence, la couche de fonctionnalisation 210 est une couche de neutralisation. Autrement dit, le premier matériau est neutre vis-à-vis du copolymère à blocs. Ce premier matériau peut être un polymère dont l'énergie de surface correspond à un régime de neutralité du copolymère à blocs destiné à occuper les cavités 310 du guide 300. Il peut notamment s'agir d'un copolymère statistique de même nature chimique (i.e. comprenant les mêmes monomères) que ce copolymère à blocs.

À titre d'exemple, lorsque le copolymère à blocs est du PS-b-PMMA de morphologie cylindrique, la couche de fonctionnalisation 210 peut être une couche du copolymère statistique PS-*r*-PMMA, comportant 70% en masse de polystyrène (PS) et 30% en masse de polyméthacrylate de méthyle (PMMA). Lorsque le copolymère à blocs est du PS-b-PMMA de morphologie lamellaire, la première couche de fonctionnalisation peut être une couche de PS-*r*-PMMA, comportant 50% en masse de PS et 50 % en masse de PMMA.

L'étape S1 de formation de la couche de fonctionnalisation 210 comporte de préférence une opération de dépôt d'une couche formée du premier matériau polymère, par exemple par dépôt à la tournette (« spin-coating » en anglais), une opération de fixation, appelé également greffage, de la couche du premier matériau polymère à la surface du substrat 200, et une opération de rinçage au cours de laquelle le surplus de matériau polymère (i.e. le matériau non-greffé) est enlevé à l'aide d'un solvant. Dans une variante de mise en œuvre, où le premier matériau polymère est réticulable plutôt que greffable, l'opération d'étalement à la tournette est suivie d'un recuit thermique afin de réticuler le premier matériau polymère.

Le substrat 200 comporte au moins une couche active, dans laquelle on prévoit de transférer les motifs secondaires obtenus par l'assemblage du copolymère à blocs, par exemple dans le but de former des trous de contact. Le substrat 200 est de préférence constitué d'un empilement de plusieurs couches, comprenant une couche de base 201 en matériau semi-conducteur, par exemple en silicium, au moins une couche active (par exemple en oxyde ou nitrure) et au moins une couche organique (ex. SOC, SOG, BARC...). Le nombre et la nature des couches de l'empilement varient en fonction de l'application envisagée.

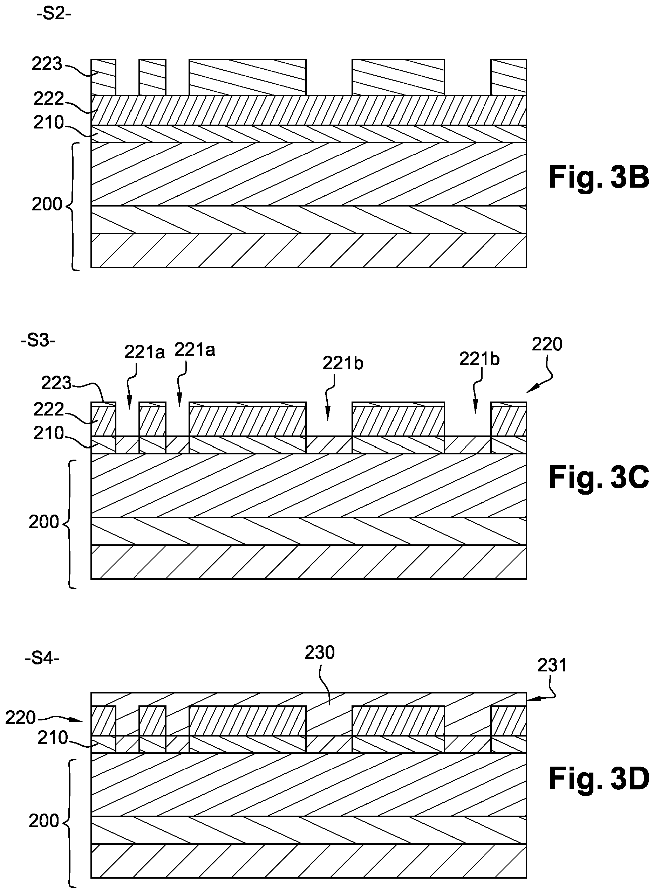

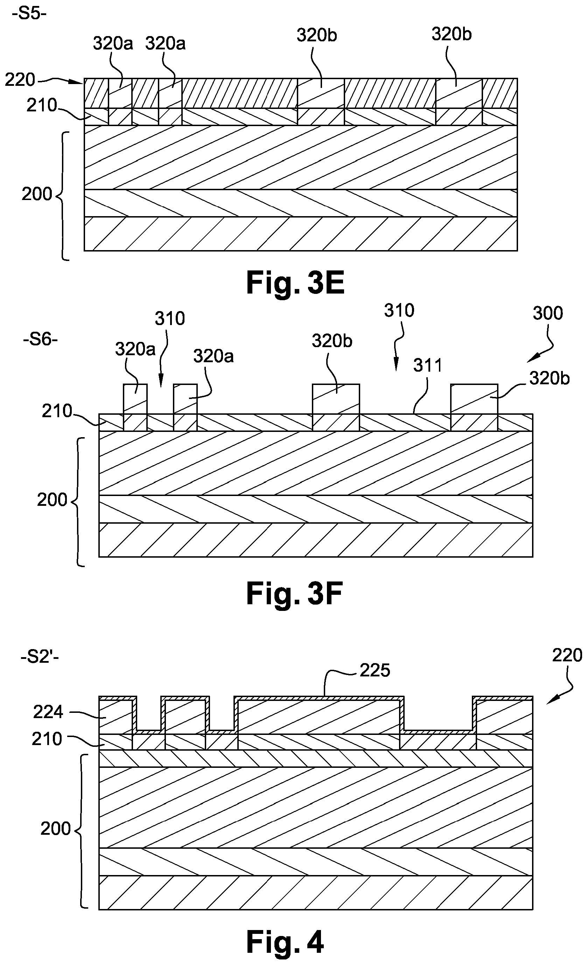

Les étapes S2 et S3 illustrées par les figures 3B et 3C ont pour but de former un masque 220 sur la couche de fonctionnalisation 210. Ce masque 220 comporte un ou plusieurs évidements, dont la forme et les dimensions correspondent au(x) motif(s) du guide d'assemblage 300 que l'on souhaite former. Autrement dit, les parties pleines du masque 220 définissent les futures cavités 310 du guide d'assemblage 300 (cf. Fig.2). Dans l'exemple représenté sur les figures 2 et 3, on souhaite former un guide d'assemblage 300 comprenant deux motifs d'assemblage 320a-320b périphériques (en vue de dessus), c'est-à-dire de contour fermé. Le masque 220 comporte alors deux évidements 221a-221b, également de forme périphérique (cf. Fig.3C). Alternativement, les motifs d'assemblage 320a-320b sont des lignes qui définissant entre elles une tranchée correspondant à la cavité 310.

Le masque 220 est, dans ce mode de mise en œuvre du procédé, un masque dur formé par photolithographie et gravure. À l'étape S2 de la figure 3B, la couche de fonctionnalisation 210 est recouverte d'au moins une couche de matériau inorganique 222, puis d'une couche de résine photosensible 223. La couche de matériau inorganique 222 est de préférence une couche antireflet, par exemple un revêtement riche en silicium (« Silicon Anti-Reflective Coating », SiARC), afin d'améliorer la qualité de la photolithographie. La couche de résine photosensible 223 est ensuite exposée et développée, afin de révéler les futurs motifs du guide d'assemblage. À l'étape S3 (Fig.3C), les motifs imprimés dans la couche de résine 223 sont transférés dans la couche de SiARC 222 sous-jacente, formant ainsi les évidements 221a-221b du masque 220. Pour ce transfert, un procédé de gravure sèche, par plasma, peut être employé.

Les évidements 221a-221b du masque 220 débouchent avantageusement sur la couche de fonctionnalisation 210. Cela implique de graver la couche de SiARC 222 sur toute sa hauteur lors de l'étape S3 de la figure 2C. De cette manière, les parois latérales des cavités du guide d'assemblage seront entièrement fonctionnalisées.

Lors de l'étape de gravure S3 des évidements 221a-221b (Fig.2C), l'affinité chimique des portions de la couche de fonctionnalisation 210 situées au fond des évidements peut avoir été modifiée par le plasma. Cela n'aura toutefois aucune d'incidence sur l'assemblage du copolymère à blocs, car ces portions ne constitueront pas le fond des cavités 310 et ne seront donc pas en contact avec le copolymère à blocs. Pour rappel, le fond des futures cavités est situé sous les parties pleines du masque 220.

L'étape S4 de la figure 3D consiste à déposer un deuxième matériau 230 sur la couche de fonctionnalisation 210 et le masque 220. Ce deuxième matériau 230 est choisi en fonction de l'affinité chimique que l'on souhaite donner aux motifs de guidage 320a-320b, dont les flancs formeront les parois latérales des cavités 310 (cf. Fig.2). Le deuxième matériau 230 peut être un matériau polymère réticulable, à l'instar du premier matériau de la couche de fonctionnalisation 210, un oxyde de silicium, un nitrure de silicium, un nitrure de titane ou un métal tel que l'or, le cuivre, le platine et le palladium.

De préférence, le deuxième matériau 230 présente une affinité préférentielle pour l'un des blocs du copolymère. Par exemple, dans le cas du copolymère di-blocs PS-*b*-PMMA, le deuxième matériau 230 peut être PMMA-affine ou PS-affine. Les dérivés styrèniques et les dérivés de méthacrylate sont respectivement des exemples de matériau PS-affine et PMMA-affine. Couplé au caractère « neutre » de la couche de fonctionnalisation 210, cette affinité préférentielle vis-à-vis d'un des blocs du copolymère permet d'orienter les motifs secondaires du copolymère à blocs (en PS ou en PMMA, selon le cas) perpendiculairement au substrat 200.

Lorsque le masque présente un taux d'ouverture uniforme, on peut ne remplir que partiellement les évidements 221a-221b du masque 220. L'épaisseur de la couche de copolymère à blocs dans les évidements 221a-221b sera sensiblement constante. Dans la configuration illustrée sur la figure 3D, où le masque présente un taux d'ouverture non uniforme (en l'espèce deux évidements 221b plus larges que les deux évidements 221a), le deuxième matériau 230 est avantageusement déposé de façon à remplir entièrement les évidements 221a-221b du masque 200 et à former une couche 231 en surépaisseur au-dessus du masque. Les conditions de dépôt sont avantageusement choisies de manière à obtenir une couche de surépaisseur 231 uniforme, c'est-à-dire d'épaisseur sensiblement constante. Pour ce faire, la surépaisseur 231 est de préférence égale à dix fois environ la profondeur des évidements 221a-221b, voire supérieure à dix fois cette profondeur. Par exemple, pour des évidements de 35 nm de profondeur environ, on cherchera à obtenir une surépaisseur de l'ordre de 300 nm.

Le dépôt du deuxième matériau 230 est avantageusement effectué par dépôt à la tournette (ou « spin coating » selon le terme anglais). Une solution contenant un solvant et le deuxième matériau (typiquement un polymère) est étalée sur le substrat 200 (recouvert de la couche de fonctionnalisation 210 et du masque 220), par force centrifuge. Ce mode de dépôt est particulièrement adapté pour aplanir une topographie de surface, comme celle générée par les évidements du masque 220, et donc obtenir une surface plane. En outre, il peut s'effectuer à température ambiante. Le risque de dégrader la couche de fonctionnalisation 210 en matériau polymère est alors nul.

D'autres modes de dépôt peuvent être envisagés selon la nature du deuxième matériau, par exemple la PECVD (« Plasma-Enhanced Chemical Vapor Déposition », dans le cas des oxydes notamment) et la CVD (« Chemical Vapor Déposition »). Le dépôt s'effectue de préférence à basse température (< 300 °C) afin de ne pas altérer la couche de fonctionnalisation 210.

Puis, à l'étape S5 de la figure 3, la couche de surépaisseur 231 formée du deuxième matériau 230 est éliminée afin de découvrir le masque 220. Le retrait du deuxième matériau 230 s'effectue de préférence jusqu'à la face supérieure du masque 220, afin d'obtenir des motifs 320a-320b en deuxième matériau de même épaisseur que le masque 220. En d'autres termes, les motifs 320a-320b de la figure 3E sont contenus entièrement dans les évidements du masque 220. Ainsi, cette étape S5 peut être appelée « étape de planarisation », en référence à la surface plane formée par les motifs 320a-320b du deuxième matériau et le masque 220.

Dans un mode de mise en œuvre de l'étape S5, la couche de surépaisseur 231 en deuxième matériau est éliminée par polissage mécano-chimique (CMP, pour « Chemical Mechanical Planarization » en anglais). Dans ce cas, pour obtenir une surface plane à l'issue de l'étape S5, il importe peu que la couche de surépaisseur 231 soit initialement d'épaisseur constante.

Dans une variante de mise en œuvre, la couche de surépaisseur 231 est éliminée par gravure plasma. La chimie de gravure est avantageusement choisie de manière à obtenir une bonne sélectivité de gravure par rapport au SiARC du masque 220. Cela permet de mieux contrôler le retrait du deuxième matériau en s'arrêtant sélectivement sur le masque 220. Le masque 220 constitue alors une couche d'arrêt de la gravure. À titre d'exemple, lorsque la couche de surépaisseur est une couche organique, on peut utiliser une chimie oxydante (à base d'O₂, mélangé avec N₂ par exemple) ou une chimie réductrice (à base de H₂, mélangé avec N₂ par exemple).

Comme l'épaisseur gravée par le plasma est sensiblement la même en tout point du substrat, il est préférable de partir d'une couche de surépaisseur 231 uniforme pour aboutir à une planéité entre les parties pleines du masque 220 et les motifs 320a-320b du deuxième matériau. On choisira pour cela une surépaisseur de l'ordre de - voire supérieure à - dix fois la profondeur des évidements.

Il est également possible de combiner le polissage mécano-chimique (CMP) et la gravure plasma pour éliminer la couche de surépaisseur 231. Il est d'ailleurs préférable d'effectuer d'abord une opération de CMP pour dégrossir la couche de surépaisseur 231, puis une opération de gravure plasma sélective, afin de terminer l'élimination en s'arrêtant avec précision sur le masque 220.

Ainsi, en faisant déborder le deuxième matériau 230 du masque 220 à l'étape S4, puis en le rabotant à hauteur du masque 220 à l'étape S5, on garantit que tous les motifs 320a-320b du guide d'assemblage auront la même épaisseur sur la couche de fonctionnalisation 210, quelle que soit leur nombre, leur dimensions et leur répartition sur la couche de fonctionnalisation 210.

Enfin, à l'étape S6 (Fig.3F), le masque est gravé sélectivement par rapport au premier matériau de la couche de fonctionnalisation 210 et au deuxième matériau, afin de libérer les motifs 320a-320b du guide d'assemblage 300. Cette étape peut être qualifiée d'étape d'inversion, car les motifs de guidage 320a-320b sont le négatif des motifs imprimés dans la couche de résine 223 à l'étape S2 de la figure 3B.

Pour ne pas modifier l'affinité chimique des portions de la couche de fonctionnalisation 210 qui constituent le fond 311 des cavités 310, le masque en SiARC est avantageusement gravé par voie humide, par exemple dans un bain d'acide fluorhydrique. En effet, d'autres types de gravure et notamment une gravure par plasma, bien qu'envisageables, risqueraient de modifier l'affinité chimique du fond 311 des cavités 310.

Un exemple de mise en œuvre particulier des étapes S1 à S6 (figures 3A à 3F) est donné ci-après. Le substrat 200 comprend, de bas en haut, une couche en silicium massif (« bulk ») 201, une couche en dioxyde de silicium (SiO₂) 202 et une couche carbonée 203 déposée par centrifugation (également appelée « SOC », pour « Spin-On-Carbon » en anglais).

Premièrement, à l'étape S1 (Fig.3A), on dépose sur environ 30 nm d'épaisseur une solution de PS-*r*-PMMA dilué à 2 % en concentration massique dans de l'éther monométhylique de propylène glycol (PGMEA). Ce dépôt est suivi d'un recuit de greffage à 230 °C pendant 10 min et d'un rinçage au PGMEA, d'où il résulte une couche greffée de PS-*r*-PMMA d'environ 8 nm d'épaisseur sur la couche carbonée 203. Cette couche greffée de PS-*r*-PMMA servira de couche de neutralisation 210.

En S2 (Fig.3B), la couche de PS-*r*-PMMA 210 est recouverte d'une couche en SiARC 222 d'environ 30 nm d'épaisseur, déposée à la tournette (i.e. par « spin coating ») et recuite à 215 °C pendant 5 min, puis d'une couche de résine 223 à tonalité de développement négative. Puis, des motifs de type ligne sont imprimés dans la couche de résine, d'environ 100 nm d'épaisseur.

En S3 (Fig.3C), les motifs imprimés dans la couche de résine 223 sont transférés par gravure dans toute l'épaisseur de la couche en SiARC 222, afin de former le masque 220. Le transfert des motifs peut être obtenu au moyen d'un plasma fluorocarboné (CHₓF_{y}), par exemple CH₂F₂ (20 sccm) + CF₄ (40 sccm) + He (240 sccm) pendant 15 secondes. Il peut être effectué dans un réacteur à couplage capacitif ou inductif.

En S4 (Fig.3D), un polystyrène réticulable 230, dilué à plus de 5 % en concentration massique dans le PGMEA, est déposé dans les évidements du masque en SiARC 220. Le polystyrène dilué est déposé à la tournette à une vitesse de 1500 tours/min pendant 30 secondes. Le masque 220 est alors recouvert d'une couche en polystyrène 231 d'épaisseur sensiblement constante, de l'ordre de 300 nm.

En S5 (Fig.3E), la couche de polystyrène 231 est gravée par un plasma à base d'oxygène ou d'hydrogène dilué ou non avec des gaz tels que N₂, Ar... jusqu'à atteindre le masque 220 en SiARC. La gravure prend fin par détection de fin d'attaque de la couche de polystyrène 231 (par suivi in situ de la longueur d'onde correspondant à la gravure de ce polymère). Le substrat est ensuite porté à une température de 180 °C pendant 100 min pour réticuler le polystyrène, ce qui confère au matériau une bonne tenue thermique.

Enfin, en S6 (Fig.3F), le masque 220 en SiARC est gravé dans un bain d'acide fluorhydrique de concentration massique égale à 0,1 % pendant 30 secondes. Ce type de gravure humide laisse intacts le PS-*r*-PMMA de la couche de neutralisation 210 et le polystyrène réticulé. Le guide d'assemblage fonctionnalisé 300 est alors formé. Il comporte des motifs en polystyrène 320a-320b et une couche de neutralisation 210, sur laquelle reposent les motifs de polystyrène (cf. Fig.3F)

La figure 4 représente une variante de mise en œuvre S2' des étapes permettant de former le masque 220 sur la couche de fonctionnalisation 210 (S2 et S3).

Dans cette variante de mise en œuvre, le masque 220 comprend une couche de résine photosensible 224, plutôt qu'une couche inorganique (masque dur). Ainsi, à l'étape S2', la couche de résine 224 est déposée sur la couche de fonctionnalisation 210, insolée puis développée afin de former les évidements 221a-221b du masque 220.

Utiliser une couche de résine plutôt qu'une couche inorganique pour former le masque permet d'atteindre plus facilement des hauteurs de motifs de guidage plus importantes. En outre, cette variante de mise en œuvre est plus économique, car la formation du masque compte une étape de moins (pas de transfert des motifs formés dans la couche de résine).

Par contre, un masque 220 en résine, c'est-à-dire en matériau polymère, peut rendre plus difficile le rabotage par plasma de l'étape S5. En effet, lorsque le deuxième matériau 230 déposé dans les évidements du masque est également un matériau polymère, il peut exister un manque de contraste chimique qui ne permet pas de retirer le deuxième matériau 230 sélectivement par rapport au matériau du masque 220. Pour remédier à ce problème, la couche de résine 224 est avantageusement recouverte, après développement, d'une fine couche d'arrêt 225 de type « liner », autrement dit déposée de manière conforme sur la couche de résine 224 et la couche de fonctionnalisation 210. Cette couche d'arrêt 225, de préférence en oxyde ou en nitrure, protège la couche de résine 224 de la gravure plasma du deuxième matériau. La couche d'arrêt 225 présente, de préférence, une épaisseur comprise entre 5 nm et 10 nm.

Après l'étape S5 de rabotage du deuxième matériau 230 (Fig.3E), la couche d'arrêt 225 recouvrant le masque en résine 220 est retirée, par exemple dans un bain d'acide fluorhydrique (HF), puis le masque 220 en résine est éliminé, de préférence au moyen d'un solvant (étape S6 ; Fig.3F).

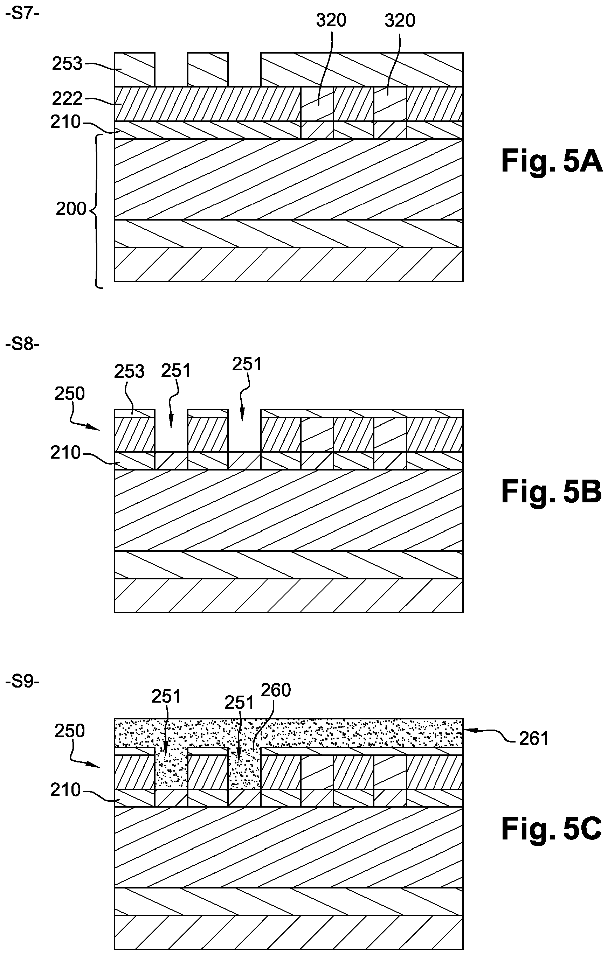

Les figures 5A à 5E représentent une variante de mise en œuvre du procédé de formation de guide d'assemblage fonctionnalisé selon l'invention. Dans cette variante, on réalise une première série de motifs de guidage 320 grâce aux étapes S1 à S5 précédemment décrites en lien avec les figures 3A à 3E. Cette première série de motifs va permettre de créer une (ou plusieurs) première(s) cavité(s) 310 dont les parois présentent une affinité correspondant au matériau de ces motifs. Au stade de la figure 3E, plutôt que de retirer le masque 220 (étape S6, Fig.3F), il est possible ensuite de réaliser un deuxième masque 250 en créant de nouvelles ouvertures 251 dans la couche en SiARC 222, par lithographie et gravure (de préférence de façon similaire aux étapes S2 et S3). Ces ouvertures 251 vont permettre de créer une deuxième série de motifs 330 délimitant une (ou plusieurs) deuxième(s) cavité(s) 340 dont l'affinité des parois est différente de l'affinité des parois de la première cavité 310.

Pour ce faire, à l'étape S7 de la figure 5A, les motifs 320 de la première série et la couche en SiARC 222 qui les entoure sont recouverts d'une deuxième couche de résine photosensible 253. Cette couche de résine photosensible 253 est ensuite exposée et développée, afin de révéler les futurs motifs de la deuxième série.

À l'étape S8 (Fig.5B), les motifs imprimés dans la deuxième couche de résine 253 sont transférés dans la couche de SiARC 222 sous-jacente, formant ainsi le deuxième masque 250 comprenant les évidements 251. Pour ce transfert, un procédé de gravure sèche, par plasma, peut être employé. Les évidements 251 du deuxième masque 250 débouchent sur la couche de fonctionnalisation 210.

Alternativement, il est possible de partir de la structure de la figure 3F (i.e. une fois le premier masque 220 retiré) et de déposer une nouvelle couche de matériau inorganique pour réaliser le deuxième masque 250. Cette couche de matériau inorganique est de préférence une couche antireflet, par exemple un revêtement riche en silicium (SiARC). Le dépôt d'une nouvelle couche inorganique permet de conférer au deuxième masque 250 de meilleures propriétés, puisque contrairement à la première couche de SiARC 222, la deuxième couche de SiARC n'aura pas subi d'étape agressive, telle que la CMP ou la gravure plasma pour supprimer le deuxième matériau excédentaire.

L'étape S9 de la figure 5C consiste à déposer un troisième matériau 260 sur la couche de fonctionnalisation 210 et le deuxième masque 250. Ce troisième matériau 260 est choisi en fonction de l'affinité chimique que l'on souhaite donner aux motifs de guidage 330 de la deuxième série, dont les flancs formeront les parois latérales de la deuxième cavité 340. Le troisième matériau 260 peut être de même nature que le deuxième matériau 230 mais présentera avantageusement une affinité vis-à-vis du copolymère à blocs différente de celle du deuxième matériau.

Par exemple, si le deuxième matériau 230 présente une affinité préférentielle pour l'un des blocs du copolymère, le troisième matériau 260 peut présenter une affinité préférentielle vis-à-vis de l'autre bloc. Couplé au caractère « neutre » de la couche de fonctionnalisation 210, ces affinités préférentielles permettront d'orienter les motifs secondaires du copolymère à blocs perpendiculairement au substrat 200 le long des parois des cavités 310 et 340, mais avec une localisation différente des blocs entre les deux cavités.

Dans un autre exemple, le deuxième matériau 230 présente une affinité préférentielle pour l'un des blocs du copolymère et le troisième matériau 260 présente un caractère neutre vis-à-vis du copolymère, comme la couche de fonctionnalisation 210. On obtiendra alors dans la première cavité 310 des motifs secondaires orientés perpendiculairement au substrat et parallèlement aux parois de la cavité, et dans la deuxième cavité 340, des motifs secondaires orientés perpendiculairement au substrat 200 et perpendiculairement aux parois de la cavité.

Comme illustré à la figure 5C, le troisième matériau 260 est avantageusement déposé de façon à remplir entièrement les évidements 251 du deuxième masque 250 et à former une couche 261 en surépaisseur au-dessus du deuxième masque 250.

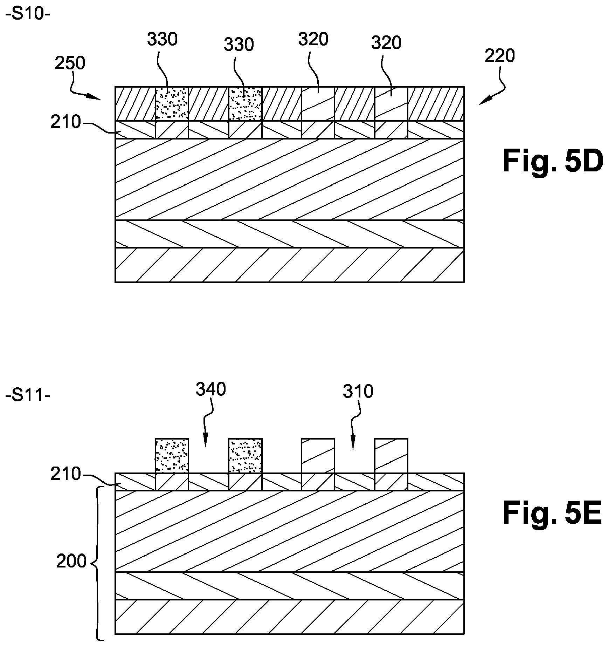

À l'étape S10 de la figure 5D, la couche de surépaisseur 261 du troisième matériau est éliminée par CMP et/ou gravure plasma afin de découvrir le deuxième masque 250 et obtenir les motifs 330 constitués du troisième matériau. Lorsqu'une seule et même couche de SiARC 222 a été utilisée pour former successivement les masques 220 et 250, les motifs 330 de la deuxième série sont de même épaisseur que les motifs 320 de la première série.

Enfin, en S11 (Fig.5E), le premier masque 220 (dont les évidements sont occupés par les motifs 320) et le deuxième masque 250 (dont les évidements sont occupés par les motifs 330) sont gravés sélectivement par rapport au premier matériau de la couche de fonctionnalisation 210 et aux deuxième et troisième matériaux, afin de libérer les motifs 320-330 du guide d'assemblage. Les masques en SiARC 220 et 250, disposés ici côte à côte, sont avantageusement gravés par voie humide, par exemple dans un bain d'acide fluorhydrique.

Le procédé qui vient d'être décrit permet donc de fabriquer un (ou plusieurs) guide d'assemblage comprenant au moins une cavité dont le fond est fonctionnalisé avec une première affinité chimique (couche de fonctionnalisation 210), tandis que les parois latérales sont fonctionnalisées avec une deuxième affinité chimique (deuxième matériau 230), voire une troisième affinité chimique (troisième matériau 260).

Le guide d'assemblage peut ensuite être utilisé dans un procédé d'auto-assemblage dirigé de copolymères à blocs (« Directed Self-Assembly », DSA), et plus particulièrement dans un procédé de grapho-épitaxie, afin de générer des motifs de très hautes résolution et densité. Ce procédé de grapho-épitaxie comporte une étape de dépôt d'un copolymère à blocs dans la (ou les) cavité(s) du guide d'assemblage et une étape d'assemblage du copolymère à blocs, par exemple par recuit.

Ce copolymère à blocs peut notamment être choisi parmi les suivants :
- PS-*b*-PMMA : polystyrène-bloc-polyméthylméthacrylate ;
- PS-*b*-PLA : polystyrène-bloc-acide polylactique ;
- PS-*b*-PEO : polystyrène-bloc-polyoxyde d'éthylène ;
- PS-*b*-PDMS : polystyrène-bloc-polydiméthylsiloxane ;
- PS-*b*-PMMA-*b*-PEO : polystyrène-bloc-polyméthylméthacrylate-bloc-polyoxyde d'éthylène ;
- PS-*b*-P2VP : polystyrène-bloc-poly(2vinylpyridine).

Naturellement, le procédé de formation de guide d'assemblage selon l'invention n'est pas limité aux modes de réalisation décrits en référence aux figures 3 à 5 et de nombreuses variantes et modifications apparaîtront à l'homme du métier. En particulier, le premier matériau de la couche de fonctionnalisation, le deuxième matériau et le troisième matériau pourraient présenter d'autres compositions que celles décrites précédemment. De même, d'autres copolymères à blocs pourraient être utilisés.

La première affinité chimique (fond de cavité) n'est pas nécessairement différente de la deuxième affinité chimique (parois latérale des cavités). En effet, d'autres combinaisons entre les première et deuxième affinités chimiques sont possibles. Le guide d'assemblage obtenu grâce au procédé selon l'invention permet ainsi d'obtenir de multiples configurations pour les motifs secondaires du copolymère à blocs.

Enfin, grâce au procédé selon l'invention, il est possible de former un guide d'assemblage comprenant une (ou plusieurs) cavité dont certaines parois présentent la deuxième affinité chimique et d'autres parois présentent une troisième affinité chimique (voire une quatrième affinité, etc.). Pour ce faire, on peut appliquer le procédé des figures 5A à 5E pour former une partie des motifs de guidage délimitant cette cavité avec le deuxième matériau et l'autre partie des motifs de guidage délimitant cette même cavité avec le troisième matériau.

## Revendications

1. Procédé de formation d'un guide d'assemblage fonctionnalisé (300) destiné à l'auto-assemblage d'un copolymère à blocs par grapho-épitaxie, comprenant les étapes suivantes :
- former (S1) à la surface d'un substrat (200) une couche de neutralisation (210) en un premier matériau présentant une première affinité chimique neutre vis-à-vis du copolymère à blocs ;
- former (S2-S3) sur la couche de neutralisation (210) un premier masque (220) comprenant au moins un évidement (221a-221b) ;
**caractérisé en ce qu'**il comporte en outre les étapes suivantes :
- déposer (S4) sur la couche de neutralisation (210) un deuxième matériau (230) présentant une deuxième affinité chimique préférentielle pour l'un des blocs du copolymère, de façon à remplir ledit au moins un évidement (221a-221b) du premier masque ; et
- graver (S6) le premier masque (220) sélectivement par rapport aux premier et deuxième matériaux, d'où il résulte au moins un motif de guidage (320a-320b) formé du deuxième matériau (230) disposé sur la couche de neutralisation (210).

2. Procédé selon la revendication 1, dans lequel ledit au moins un motif de guidage délimite au moins en partie une cavité de profondeur comprise entre 50 nm et 300 nm.

3. Procédé selon l'une des revendications 1 et 2, dans lequel le deuxième matériau (230) est déposé de manière à remplir entièrement ledit au moins un évidement (221a-221b) du premier masque (220) et à former une surépaisseur (231) au-dessus du premier masque, le procédé comprenant en outre, avant l'étape de gravure (S6) du premier masque (220), une étape (S5) consistant à éliminer la surépaisseur (231) afin de découvrir le premier masque.

4. Procédé selon la revendication 3, dans lequel la surépaisseur (231) du deuxième matériau (230) est éliminée par planarisation mécano-chimique.

5. Procédé selon la revendication 3, dans lequel la surépaisseur (231) du deuxième matériau (230) est éliminée par gravure plasma.

6. Procédé selon la revendication 5, dans lequel le deuxième matériau (230) est déposé de sorte que la surépaisseur (231) du deuxième matériau présente une surface plane et dans lequel le deuxième matériau est gravé de manière uniforme.

7. Procédé selon l'une quelconque des revendications 1 à 6, dans lequel le premier masque (220) est gravé par voie humide.

8. Procédé selon l'une quelconque des revendications 1 à 7, dans lequel la couche de neutralisation (210) est formée d'un copolymère statistique de même nature chimique que le copolymère à blocs, et dans lequel le deuxième matériau (230) est choisi parmi un polymère réticulable, un oxyde de silicium, un nitrure de silicium, un nitrure de titane et un métal.

9. Procédé selon l'une quelconque des revendications 1 à 8, dans lequel le premier masque (220) est un masque dur comprenant une couche anti-réflective (222).

10. Procédé selon l'une quelconque des revendications 1 à 8, dans lequel le premier masque (220) comprend une couche de résine photosensible (224).

11. Procédé selon la revendication 10, comprenant en outre le dépôt conforme d'une couche d'arrêt (225) sur la couche (224) de résine photosensible.

12. Procédé selon l'une quelconque des revendications 1 à 11, comprenant en outre les étapes suivantes :
- former (S7-S8) sur la couche de neutralisation (210) un deuxième masque (250) comprenant au moins un évidement (251) ;
- déposer (S9) un troisième matériau (260) présentant une troisième affinité chimique vis-à-vis du copolymère à blocs, de façon à remplir ledit au moins un évidement (251) du deuxième masque (250) ; et
- graver (S11) le deuxième masque (250) sélectivement par rapport aux premier, deuxième et troisième matériaux, d'où il résulte au moins un motif de guidage (330) formé du troisième matériau (260) disposé sur la couche de neutralisation (210).

13. Procédé selon la revendication 12, dans lequel les premier et deuxième masques (220, 250) sont formés successivement dans une même couche inorganique (222) et gravés simultanément.

14. Procédé selon la revendication 12, dans lequel le deuxième masque (250) est formé sur la couche de neutralisation (210) après la gravure (S6) du premier masque (220).

15. Procédé de grapho-épitaxie comprenant :
- la formation d'un guide d'assemblage fonctionnalisé (300) à l'aide d'un procédé selon l'une quelconque des revendications 1 à 14, le guide d'assemblage comprenant au moins une cavité (310) ; et
- le dépôt d'un copolymère à blocs à l'intérieur de la cavité (310).

## Patentansprüche

1. Verfahren zum Bilden einer funktionalisierten Assemblierungsführung (300) für die Selbstassemblierung eines Blockcopolymers durch Graphoepitaxie, umfassend die folgenden Schritte:
- Bilden (S1) einer Neutralisierungsschicht (210) aus einem ersten Material mit einer ersten chemischen Affinität, die gegenüber dem Blockcopolymer neutral ist, auf der Oberfläche eines Substrats (200);
- Bilden (S2-S3) einer ersten Maske (220), die mindestens eine Aussparung (221a-221b) umfasst, auf der Neutralisierungsschicht (210);
ferner **dadurch gekennzeichnet, dass** es die folgenden Schritte umfasst:
- Auftragen (S4) eines zweiten Materials (230) mit einer zweiten chemischen Affinität, die zu einem der Blöcke des Copolymers hoch ist, auf die Neutralisierungsschicht (210), sodass die mindestens eine Aussparung (221a-221b) der ersten Maske gefüllt wird; und
- Ätzen (S6) der ersten Maske (220), selektiv in Bezug auf das erste und zweite Material, woraus mindestens ein Führungsmuster (320a-320b) entsteht, das aus dem zweiten Material (230) gebildet wird, das auf der Neutralisierungsschicht (210) aufgebracht ist.

2. Verfahren nach Anspruch 1, wobei das mindestens eine Führungsmuster zumindest teilweise einen Hohlraum mit einer Tiefe zwischen 50 nm und 300 nm begrenzt.

3. Verfahren nach einem der Ansprüche 1 oder 2, wobei das zweite Material (230) so aufgetragen wird, dass es die mindestens eine Aussparung (221a-221b) der ersten Maske (220) vollständig füllt und eine Überdicke (231) über der ersten Maske bildet, wobei das Verfahren ferner vor dem Schritt des Ätzens (S6) der ersten Maske (220) einen Schritt (S5) bestehend aus dem Entfernen der Überdicke (231) umfasst, um die erste Maske freizulegen.

4. Verfahren nach Anspruch 3, wobei die Überdicke (231) des zweiten Materials (230) durch chemisch-mechanische Planarisierung entfernt wird.

5. Verfahren nach Anspruch 3, wobei die Überdicke (231) des zweiten Materials (230) durch Plasmaätzen entfernt wird.

6. Verfahren nach Anspruch 5, wobei das zweite Material (230) so aufgetragen wird, dass die Überdicke (231) des zweiten Materials eine ebene Oberfläche aufweist, und wobei das zweite Material gleichmäßig geätzt wird.

7. Verfahren nach einem der Ansprüche 1 bis 6, wobei die erste Maske (220) nassgeätzt wird.

8. Verfahren nach einem der Ansprüche 1 bis 7, wobei die Neutralisierungsschicht (210) aus einem statistischen Copolymer derselben chemischen Art wie das Blockcopolymer gebildet ist, und wobei das zweite Material (230) aus einem vernetzbaren Polymer, einem Siliciumoxid, einem Siliciumnitrid, einem Titannitrid und einem Metall ausgewählt wird.

9. Verfahren nach einem der Ansprüche 1 bis 8, wobei die erste Maske (220) eine Hartmaske ist, die eine Antireflexschicht (222) umfasst.

10. Verfahren nach einem der Ansprüche 1 bis 8, wobei die erste Maske (220) eine lichtempfindliche Harzschicht (224) umfasst.

11. Verfahren nach Anspruch 10, ferner umfassend das konforme Auftragen einer Sperrschicht (225) auf die lichtempfindliche Harzschicht (224).

12. Verfahren nach einem der Ansprüche 1 bis 11, ferner umfassend die folgenden Schritte:
- Bilden (S7-S8) einer zweiten Maske (250), die mindestens eine Aussparung (251) umfasst, auf der Neutralisierungsschicht (210);
- Auftragen (S9) eines dritten Materials (260) mit einer dritten chemischen Affinität zu dem Blockcopolymer, sodass die mindestens eine Aussparung (251) der zweiten Maske (250) gefüllt wird; und
- Ätzen (S11) der zweiten Maske (250), selektiv in Bezug auf das erste, zweite und dritte Material, woraus mindestens ein Führungsmuster (330) entsteht, das aus dem dritten Material (260) gebildet wird, das auf der Neutralisierungsschicht (210) aufgebracht ist.

13. Verfahren nach Anspruch 12, bei dem die erste und die zweite Maske (220, 250) nacheinander in derselben anorganischen Schicht (222) gebildet und gleichzeitig geätzt werden.

14. Verfahren nach Anspruch 12, wobei die zweite Maske (250) auf der Neutralisierungsschicht (210) nach dem Ätzen (S6) der ersten Maske (220) gebildet wird.

15. Verfahren zur Graphoepitaxie, umfassend:
- Bildung einer funktionalisierten Assemblierungsführung (300) durch ein Verfahren nach einem der Ansprüche 1 bis 14, wobei die Assemblierungsführung mindestens einen Hohlraum (310) umfasst; und
- Auftragung eines Blockcopolymers innerhalb des Hohlraums (310).

## Claims

1. Method for forming a functionalised assembly guide (300) intended for the self-assembly of a block copolymer by graphoepitaxy, comprising the following steps:
- forming (S1) on the surface of a substrate (200) a neutralisation layer (210) made of a first material having a first neutral chemical affinity with regard to the block copolymer;
- forming (S2-S3) on the neutralisation layer (210) a first mask (220) comprising at least one recess (221a-221b);
**characterised in that** it further comprises the following steps:
- depositing (S4) on the neutralisation layer (210) a second material (230) having a second preferential chemical affinity for one of the copolymer blocks, in such a way as to fill said at least one recess (221a-221b) of the first mask; and
- selectively etching (S6) the first mask (220) relative to the first and second materials, thereby forming at least one guide pattern (320a-320b) made of the second material (230) arranged on the neutralisation layer (210).

2. Method according to claim 1, wherein said at least one guide pattern delimits at least in part a cavity of depth comprised between 50 nm and 300 nm.

3. Method according to one of claims 1 and 2, wherein the second material (230) is deposited so as to fill entirely said at least one recess (221a-221b) of the first mask (220) and to form an extra thickness (231) above the first mask, the method further comprising, before the step of etching (S6) the first mask (220), a step (S5) consisting in removing the extra thickness (231) in order to uncover the first mask.

4. Method according to claim 3, wherein the extra thickness (231) of the second material (230) is removed by chemical mechanical planarization.

5. Method according to claim 3, wherein the extra thickness (231) of the second material (230) is removed by plasma etching.

6. Method according to claim 5, wherein the second material (230) is deposited such that the extra thickness (231) of the second material has a flat surface and wherein the second material is etched in a uniform manner.

7. Method according to any of claims 1 to 6, wherein the first mask (220) is etched by wet process.

8. Method according to any of claims 1 to 7, wherein the neutralisation layer (210) is formed of a random copolymer of same chemical nature as the block copolymer, and wherein the second material (230) is selected from a cross-linkable polymer, a silicon oxide, a silicon nitride, a titanium nitride and a metal.

9. Method according to any of claims 1 to 8, wherein the first mask (220) is a hard mask comprising an antireflective layer (222).

10. Method according to any of claims 1 to 8, wherein the first mask (220) comprises a photosensitive resin layer (224).

11. Method according to claim 10, further comprising the conformal deposition of a stop layer (225) on the photosensitive resin layer (224).

12. Method according to any of claims 1 to 11, further comprising the following steps:
- forming (S7-S8) on the neutralisation layer (210) a second mask (250) comprising at least one recess (251);
- depositing (S9) a third material (260) having a third chemical affinity with regard to the block copolymer, in such a way as to fill said at least one recess (251) of the second mask (250); and
- selectively etching (S11) the second mask (250) relative to the first, second and third materials, thereby forming at least one guide pattern (330) made of the third material (260) arranged on the neutralisation layer (210).

13. Method according to claim 12, wherein the first and second masks (220, 250) are formed successively in a same inorganic layer (222) and etched simultaneously.

14. Method according to claim 12, wherein the second mask (250) is formed on the neutralisation layer (210) after etching (S6) the first mask (220).

15. Graphoepitaxy method comprising:
- the formation of a functionalised assembly guide (300) using a method according to any of claims 1 to 14, the assembly guide comprising at least one cavity (310); and
- the deposition of a block copolymer inside the cavity (310).
